# EUROPÄISCHE PATENTSCHRIFT

(11) **EP 4 605 761 B1**
(45) Veröffentlichungstag und Bekanntmachung des Hinweises auf die Patenterteilung: **09.12.2026**
(21) Anmeldenummer: 23786006.9
(22) Anmeldetag: 02.10.2023
(51) Int. Cl.: G01R 19/25, G01R 19/00

(54) **VERFAHREN UND VORRICHTUNG ZUM MESSEN EINES ELEKTRISCHEN STROMS**
METHOD AND DEVICE FOR MEASURING AN ELECTRIC CURRENT
PROCÉDÉ ET DISPOSITIF DE MESURE D'UN COURANT ÉLECTRIQUE

(30) Priorität: 20.10.2022 DE 102022211104
(43) Veröffentlichungstag der Anmeldung: 27.08.2025
(73) Patentinhaber: HSP Hochspannungsgeräte GmbH, 53842 Troisdorf (DE)
(72) Erfinder: SCHUBERTH, Stefan, 96215 Lichtenfels-Schney (DE)
(74) Vertreter: Betten & Resch
(86) Internationale Anmeldenummer: PCT/EP2023/077261
(87) Internationale Veröffentlichungsnummer: WO 2024/083492

(56) Entgegenhaltungen:
- WO-A1-2017/103672
- US-A1- 2012 200 284
- US-A1- 2012 296 587

## Beschreibung

Die Erfindung betrifft ein Verfahren und eine Messvorrichtung zum Messen eines elektrischen Stroms.

Messsignale von Messungen elektrischer Ströme werden häufig von einem meist breitbandigen Rauschen überlagert. Um dieses Rauschen zu unterdrücken, werden Filter eingesetzt. Ein Filter ist ein System, das ein Eingangssignal mit einer Übertragungsfunktion verknüpft und dieses veränderte Signal an seinem Ausgang zur Verfügung stellt. Filter dienen in der Messtechnik vor allem dazu, dass meist breitbandige Rauschen, welches einem Messsignal überlagert ist, von diesem teilweise zu trennen. So kann ein schmalbandiger Bereich des Messsignals isoliert werden, der weniger Rauschen enthält. Im Falle eines Stromwandlers zum Messen eines elektrischen Stroms liegt die Hauptfrequenz des Messsignals typischerweise bei 50 Hz oder 60 Hz. Für diesen Fall bietet sich eine Tiefpassfilterung der Messsignale an. Die resultierende gefilterte Kurve der Messsignale in Abhängigkeit von deren Frequenzen ist glatt, enthält wenig Rauschen und ist mit weiterführenden Algorithmen leicht zu verarbeiten. Ein Nachteil einer Tiefpassfilterung liegt allerdings darin, dass die gefilterte Kurve nur langsam auf Änderungen des Messsignals reagiert. Mit anderen Worten wird eine verbesserte Signalqualität durch eine Zeitträgheit erkauft. Detektionen schneller Änderungen von Messsignalen sind mit tiefpassgefilterten Messsignalen nicht möglich.

US 2012/296587 A1 offenbart eine Vorrichtung zur Berechnung eines geglätteten Stroms.

WO 2017/103672 A1 offenbart Systeme und Verfahren zum dynamischen Steuern der sensorbasierten Datenerfassung in Fahrzeugen.

Der Erfindung liegt die Aufgabe zugrunde, ein verbessertes Verfahren und eine verbesserte Messvorrichtung zum Messen eines elektrischen Stroms anzugeben.

Die Aufgabe wird erfindungsgemäß durch ein Verfahren mit den Merkmalen des Anspruchs 1 und durch eine Messvorrichtung mit den Merkmalen des Anspruchs 10 gelöst.

Vorteilhafte Ausgestaltungen der Erfindung sind Gegenstand der Unteransprüche.

Bei dem erfindungsgemäßen Verfahren zum Messen eines elektrischen Stroms wird wiederholt ein von dem Strom abhängiges Messsignal erfasst und für jedes Messsignal wird ein gefiltertes Messsignal gebildet, indem das Messsignal mit einem Bandpassfilter gefiltert wird. Ferner werden für jedes Messsignal die erste Ableitung des Messsignals nach der Zeit und die erste Ableitung eines Leistungsdichtewertes nach der Zeit bestimmt, wobei der Leistungsdichtewert aus einer spektralen Leistungsdichte des Messsignals gebildet wird. Als Maß für die Stromstärke des Stroms wird ein gewichteter Mittelwert des Messsignals und des gefilterten Messsignals gebildet, wobei das Gewicht des Messsignals mit steigender erster Ableitung des Messsignals nach der Zeit und mit steigender erster Ableitung des Leistungsdichtewertes nach der Zeit monoton zunimmt.

Die Erfindung sieht also vor, als Maß für die Stromstärke eines zu messenden Stroms aus dem eigentlichen Messsignal und dem mit einem Bandpassfilter gefilterten Messsignal einen gewichteten Mittelwert zu bilden. Das Gewicht des Messsignals nimmt dabei mit steigender erster Ableitung des Messsignals nach der Zeit und mit steigender erster Ableitung eines Leistungsdichtewertes nach der Zeit monoton zu. Dementsprechend nimmt das Gewicht des gefilterten Messsignals mit steigender erster Ableitung des Messsignals nach der Zeit und mit steigender erster Ableitung des Leistungsdichtewertes nach der Zeit monoton ab. Der Leistungsdichtewert wird dabei aus einer spektralen Leistungsdichte des Messsignals gebildet. Die erste Ableitung des Leistungsdichtewertes nach der Zeit ist ein Maß für die zeitliche Änderung der Frequenzverteilung des Messsignals. Die erfindungsgemäße Bildung eines Maßes für die Stromstärke eines zu messenden Stroms aus dem eigentlichen Messsignal und einem gefilterten Messsignal berücksichtigt die obigen Ausführungen, dass die Filterung des Messsignals Rauschen unterdrückt und die Auswertbarkeit des Messsignals erleichtert, sich jedoch nicht für eine Auswertung sich schnell ändernder Messsignale eignet. Das erfindungsgemäße Verfahren liefert somit Messsignale, die bei langsamen Änderungen der Messsignale ein geringes Rauschen, bei schnellen Änderungen aber eine hohe Bandbreite aufweisen.

Bei einer Ausgestaltung der Erfindung wird ein Stabilitätsfaktor definiert, der mit steigender erster Ableitung des Messsignals nach der Zeit und mit steigender erster Ableitung des Leistungsdichtewertes nach der Zeit monoton abnimmt, und der gewichtete Mittelwert des Messsignals und des gefilterten Messsignals wird mit dem Stabilitätsfaktor derart gebildet, dass das Gewicht des Messsignals mit steigendem Stabilitätsfaktor abnimmt und das Gewicht des gefilterten Messsignals mit steigendem Stabilitätsfaktor zunimmt.

Beispielsweise werden dem Stabilitätsfaktor Werte in dem Intervall [0,1] zugewiesen und der gewichtete Mittelwert wird gemäß A·(1-S) + B·S gebildet, wobei A das Messsignal bezeichnet, B das von dem Bandpassfilter gefilterte Messsignal bezeichnet und S den Wert des Stabilitätsfaktors bezeichnet. Bei einer derartigen Bildung des gewichteten Mittelwerts werden auch durch das Bandpassfilter erzeugte Phasenverschiebungen durch die gewichtete Mittelung stetig und kontinuierlich angepasst.

Bei einer weiteren Ausgestaltung der Erfindung wird ein erster Schwellenwert für die erste Ableitung des Messsignals nach der Zeit vorgegeben und der Stabilitätsfaktor wird derart definiert, dass er für alle Werte der ersten Ableitung des Messsignals nach der Zeit, die den ersten Schwellenwert überschreiten, ein Minimum seines Wertebereichs annimmt.

Bei einer weiteren Ausgestaltung der Erfindung wird ein zweiter Schwellenwert für die erste Ableitung des Leistungsdichtewertes nach der Zeit vorgegeben und der Stabilitätsfaktor wird derart definiert, dass er für alle Werte der ersten Ableitung des Leistungsdichtewertes nach der Zeit, die den zweiten Schwellenwert überschreiten, ein Minimum seines Wertebereichs annimmt.

Bei einer weiteren Ausgestaltung der Erfindung wird ein dritter Schwellenwert für die erste Ableitung des Messsignals nach der Zeit vorgegeben und der Stabilitätsfaktor wird derart definiert, dass er für alle Werte der ersten Ableitung des Messsignals nach der Zeit, die den dritten Schwellenwert unterschreiten, ein Maximum seines Wertebereichs annimmt.

Bei einer weiteren Ausgestaltung der Erfindung wird ein vierter Schwellenwert für die erste Ableitung des Leistungsdichtewertes nach der Zeit vorgegeben und der Stabilitätsfaktor wird derart definiert, dass er für alle Werte der ersten Ableitung des Leistungsdichtewertes nach der Zeit, die den vierten Schwellenwert unterschreiten, ein Maximum seines Wertebereichs annimmt.

Durch den ersten Schwellenwert und den zweiten Schwellenwert werden dabei jeweils Werte der ersten Ableitungen des Messsignals und des Leistungsdichtewertes nach der Zeit festgelegt, oberhalb derer die Wichtung des Messsignals maximal ist. Entsprechend werden durch den dritten Schwellenwert und den vierten Schwellenwert jeweils Werte der ersten Ableitungen des Messsignals und des Leistungsdichtewertes nach der Zeit festgelegt, unterhalb derer die Wichtung des gefilterten Messsignals maximal ist.

Bei einer weiteren Ausgestaltung der Erfindung ist das Bandpassfilter ein Tiefpassfilter. Diese Ausgestaltung der Erfindung ist insbesondere vorteilhaft, wenn die Hauptfrequenz des Messsignals relativ klein ist, beispielsweise 50 Hz oder 60 Hz.

Bei einer weiteren Ausgestaltung der Erfindung wird der Leistungsdichtewert durch Integration der spektralen Leistungsdichte des Messsignals über einen Frequenzbereich gebildet.

Eine erfindungsgemäße Messvorrichtung zum Messen eines elektrischen Stroms umfasst
- einen Stromwandler, der eingerichtet ist, wiederholt ein von dem Strom abhängiges Messsignal zu erfassen,
- ein Bandpassfilter, das eingerichtet ist, für jedes Messsignal ein gefiltertes Messsignal zu bilden, und
- eine Auswerteeinheit, die eingerichtet ist,
- für jedes Messsignal die erste Ableitung des Messsignals nach der Zeit und die erste Ableitung eines Leistungsdichtewertes des Messsignals nach der Zeit zu bestimmen, wobei der Leistungsdichtewert aus einer spektralen Leistungsdichte des Messsignals gebildet wird, und
- als Maß für die Stromstärke des Stroms einen gewichteten Mittelwert des Messsignals und des gefilterten Messsignals zu bilden, wobei das Gewicht des Messsignals mit steigender erster Ableitung des Messsignals nach der Zeit und mit steigender erster Ableitung des Leistungsdichtewertes nach der Zeit monoton zunimmt.

Beispielsweise ist das Bandpassfilter ein Tiefpassfilter. Der Stromwandler ist beispielsweise ein optischer Stromwandler.

Die Auswerteeinheit ist beispielsweise eingerichtet, den Leistungsdichtewert durch Integration der spektralen Leistungsdichte des Messsignals über einen Frequenzbereich zu bilden.

Eine erfindungsgemäße Messvorrichtung ermöglicht die Durchführung des erfindungsgemäßen Verfahrens. Die Vorteile einer derartigen Messvorrichtung entsprechen den oben genannten Vorteilen des erfindungsgemäßen Verfahrens.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
FIG 1 ein Blockdiagramm eines Ausführungsbeispiels einer erfindungsgemäßen Messvorrichtung zum Messen eines elektrischen Stroms,
FIG 2 ein Ablaufdiagramm eines Ausführungsbeispiels eines erfindungsgemäßen Verfahrens zum Messen eines elektrischen Stroms.

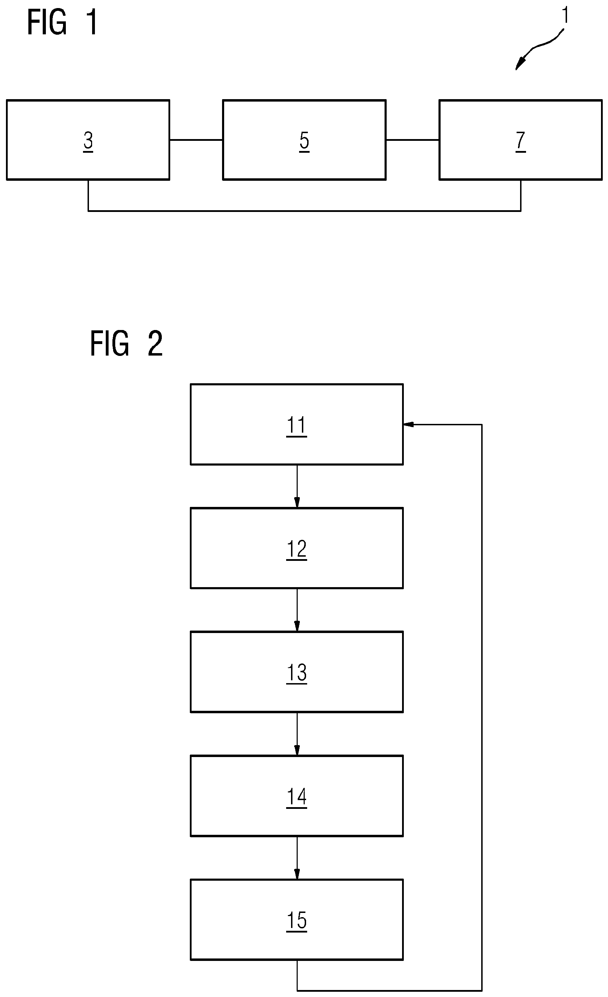

Figur 1 (FIG 1) zeigt ein Blockdiagramm eines Ausführungsbeispiels einer erfindungsgemäßen Messvorrichtung 1 zum Messen eines elektrischen Stroms. Die Messvorrichtung 1 umfasst einen Stromwandler 3, ein Bandpassfilter 5 und eine Auswerteeinheit 7.

Der Stromwandler 3 ist eingerichtet, wiederholt ein von dem Strom abhängiges Messsignal zu erfassen. Der Stromwandler 3 ist beispielsweise ein optischer Stromwandler.

Das Bandpassfilter 5 ist eingerichtet, für jedes Messsignal ein gefiltertes Messsignal zu bilden. Das Bandpassfilter 5 ist beispielsweise ein analoges oder digitales Tiefpassfilter.

Die Auswerteeinheit 7 ist eingerichtet, für jedes Messsignal die erste Ableitung des Messsignals nach der Zeit und die erste Ableitung eines Leistungsdichtewertes des Messsignals nach der Zeit zu bestimmen, wobei der Leistungsdichtewert aus einer spektralen Leistungsdichte des Messsignals gebildet wird. Beispielsweise ist die Auswerteeinheit 7 eingerichtet, den Leistungsdichtewert durch Integration der spektralen Leistungsdichte des Messsignals über einen Frequenzbereich zu bilden.

Ferner ist die Auswerteeinheit 7 eingerichtet, als Maß für die Stromstärke des Stroms einen durch einen Stabilitätsfaktor, der mit steigender erster Ableitung des Messsignals und mit steigender erster Ableitung des Leistungsdichtewertes monoton abnimmt, gewichteten Mittelwert des Messsignals und des gefilterten Messsignals zu bilden, wobei das Gewicht des Messsignals mit steigendem Stabilitätsfaktor abnimmt und das Gewicht des gefilterten Messsignals mit steigendem Stabilitätsfaktor zunimmt.

Figur 2 (FIG 2) zeigt ein Ablaufdiagramm eines Ausführungsbeispiels eines erfindungsgemäßen Verfahrens mit Verfahrensschritten 11 bis 15 zum Messen eines elektrischen Stroms. Das Verfahren wird mit einer anhand von Figur 1 beschriebenen Messvorrichtung 1 ausgeführt.

In einem ersten Verfahrensschritt 11 wird mit dem Stromwandler 3 der Messvorrichtung 1 ein von dem Strom abhängiges Messsignal erfasst.

In einem zweiten Verfahrensschritt 12 wird das in dem ersten Verfahrensschritt 11 erfasste Messsignal mit dem Bandpassfilter 5 der Messvorrichtung 1 gefiltert.

In einem dritten Verfahrensschritt 13 werden mit der Auswerteeinheit 7 der Messvorrichtung 1 für das in dem ersten Verfahrensschritt 11 erfasste Messsignal die erste Ableitung des Messsignals nach der Zeit und die erste Ableitung eines Leistungsdichtewertes des Messsignals nach der Zeit bestimmt. Die erste Ableitung des Messsignals nach der Zeit und die erste Ableitung eines Leistungsdichtewertes des Messsignals nach der Zeit werden dabei unter Verwendung mehrerer Messsignale bestimmt, die von dem Stromwandler 3 zu unterschiedlichen Zeitpunkten erfasst wurden. Der Leistungsdichtewert wird aus einer spektralen Leistungsdichte des Messsignals gebildet, beispielsweise durch Integration der spektralen Leistungsdichte des Messsignals über einen Frequenzbereich.

In einem vierten Verfahrensschritt 14 wird von der Auswerteeinheit 7 ein von der ersten Ableitung des Messsignals nach der Zeit und der ersten Ableitung des Leistungsdichtewertes nach der Zeit abhängiger Stabilitätsfaktor gebildet. Der Stabilitätsfaktor wird derart definiert, dass er mit steigender erster Ableitung des Messsignals nach der Zeit und mit steigender erster Ableitung des Leistungsdichtewertes nach der Zeit monoton abnimmt.

Beispielsweise wird ein erster Schwellenwert für die erste Ableitung des Messsignals nach der Zeit vorgegeben und der Stabilitätsfaktor wird derart definiert, dass er für alle Werte der ersten Ableitung des Messsignals nach der Zeit, die den ersten Schwellenwert überschreiten, ein Minimum seines Wertebereichs annimmt.

Ferner wird beispielsweise ein zweiter Schwellenwert für die erste Ableitung des Leistungsdichtewertes nach der Zeit vorgegeben und der Stabilitätsfaktor wird derart definiert, dass er für alle Werte der ersten Ableitung des Leistungsdichtewert nach der Zeit, die den zweiten Schwellenwert überschreiten, ein Minimum seines Wertebereichs annimmt.

Alternativ oder zusätzlich wird ein dritter Schwellenwert für die erste Ableitung des Messsignals nach der Zeit vorgegeben und der Stabilitätsfaktor wird derart definiert, dass er für alle Werte der ersten Ableitung des Messsignals nach der Zeit, die den dritten Schwellenwert unterschreiten, ein Maximum seines Wertebereichs annimmt.

Des Weiteren wird beispielsweise ein vierter Schwellenwert für die erste Ableitung des Leistungsdichtewertes nach der Zeit vorgegeben und der Stabilitätsfaktor wird derart definiert, dass er für alle Werte der ersten Ableitung des Leistungsdichtewertes nach der Zeit, die den vierten Schwellenwert unterschreiten, ein Maximum seines Wertebereichs annimmt.

Beispielsweise nimmt der Stabilitätsfaktor Werte in dem Intervall [0,1] an, so dass das Minimum seines Wertebereichs die Zahl Null ist und das Maximum seines Wertebereichs die Zahl Eins ist.

In einem fünften Verfahrensschritt 15 wird von der Auswerteeinheit 7 als Maß für die Stromstärke des Stroms ein gewichteter Mittelwert des von dem Stromwandler 3 in dem ersten Verfahrensschritt 11 erfassten Messsignals und des von dem Bandpassfilter 5 in dem zweiten Verfahrensschritt 12 gefilterten Messsignals gebildet, wobei das Gewicht des Messsignals mit steigendem Stabilitätsfaktor abnimmt und das Gewicht des gefilterten Messsignals mit steigendem Stabilitätsfaktor zunimmt.

Beispielsweise wird als Maß für die Stromstärke des Stroms ein gewichteter Mittelwert C gemäß C = A·(1-S) + B·S gebildet, wobei A das von dem Stromwandler 3 in dem ersten Verfahrensschritt 11 erfasste Messsignal bezeichnet, B das von dem Bandpassfilter 5 in dem zweiten Verfahrensschritt 12 gefilterte Messsignal bezeichnet und S den von der Auswerteeinheit 7 in dem vierten Verfahrensschritt 14 gebildeten Stabilitätsfaktor bezeichnet.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Verfahren zum Messen eines elektrischen Stroms, wobei
- wiederholt ein von dem Strom abhängiges Messsignal erfasst wird,
- für jedes Messsignal ein gefiltertes Messsignal gebildet wird, indem das Messsignal mit einem Bandpassfilter (5) gefiltert wird,
**dadurch gekennzeichnet, dass**
- für jedes Messsignal die erste Ableitung des Messsignals nach der Zeit und die erste Ableitung eines Leistungsdichtewertes nach der Zeit bestimmt werden, wobei der Leistungsdichtewert aus einer spektralen Leistungsdichte des Messsignals gebildet wird, und
- als Maß für die Stromstärke des Stroms ein gewichteter Mittelwert des Messsignals und des gefilterten Messsignals gebildet wird, wobei das Gewicht des Messsignals mit steigender erster Ableitung des Messsignals nach der Zeit und mit steigender erster Ableitung des Leistungsdichtewertes nach der Zeit monoton zunimmt.

2. Verfahren nach Anspruch 1, wobei ein Stabilitätsfaktor definiert wird, der mit steigender erster Ableitung des Messsignals nach der Zeit und mit steigender erster Ableitung des Leistungsdichtewertes nach der Zeit monoton abnimmt, und der gewichtete Mittelwert des Messsignals und des gefilterten Messsignals mit dem Stabilitätsfaktor derart gebildet wird, dass das Gewicht des Messsignals mit steigendem Stabilitätsfaktor abnimmt und das Gewicht des gefilterten Messsignals mit steigendem Stabilitätsfaktor zunimmt.

3. Verfahren nach Anspruch 2, wobei dem Stabilitätsfaktor Werte in dem Intervall [0,1] zugewiesen werden und der gewichtete Mittelwert gemäß A·(1-S) + B·S gebildet wird, wobei A das Messsignal bezeichnet, B das gefilterte Messsignal bezeichnet und S den Wert des Stabilitätsfaktors bezeichnet.

4. Verfahren nach Anspruch 2 oder 3, wobei ein erster Schwellenwert für die erste Ableitung des Messsignals nach der Zeit vorgegeben wird und der Stabilitätsfaktor derart definiert wird, dass er für alle Werte der ersten Ableitung des Messsignals nach der Zeit, die den ersten Schwellenwert überschreiten, ein Minimum seines Wertebereichs annimmt.

5. Verfahren nach einem der Ansprüche 2 bis 4, wobei ein zweiter Schwellenwert für die erste Ableitung des Leistungsdichtewertes nach der Zeit vorgegeben wird und der Stabilitätsfaktor derart definiert wird, dass er für alle Werte der ersten Ableitung des Leistungsdichtewertes nach der Zeit, die den zweiten Schwellenwert überschreiten, ein Minimum seines Wertebereichs annimmt.

6. Verfahren nach einem der Ansprüche 2 bis 5, wobei ein dritter Schwellenwert für die erste Ableitung des Messsignals nach der Zeit vorgegeben wird und der Stabilitätsfaktor derart definiert wird, dass er für alle Werte der ersten Ableitung des Messsignals nach der Zeit, die den dritten Schwellenwert unterschreiten, ein Maximum seines Wertebereichs annimmt.

7. Verfahren nach einem der Ansprüche 2 bis 6, wobei ein vierter Schwellenwert für die erste Ableitung des Leistungsdichtewertes nach der Zeit vorgegeben wird und der Stabilitätsfaktor derart definiert wird, dass er für alle Werte der ersten Ableitung des Leistungsdichtewertes nach der Zeit, die den vierten Schwellenwert unterschreiten, ein Maximum seines Wertebereichs annimmt.

8. Verfahren nach einem der vorhergehenden Ansprüche, wobei das Bandpassfilter (5) ein Tiefpassfilter ist.

9. Verfahren nach einem der vorhergehenden Ansprüche, wobei der Leistungsdichtewert durch Integration der spektralen Leistungsdichte des Messsignals über einen Frequenzbereich gebildet wird.

10. Messvorrichtung (1) zum Messen eines elektrischen Stroms, umfassend
- einen Stromwandler (3), der eingerichtet ist, wiederholt ein von dem Strom abhängiges Messsignal zu erfassen,
- ein Bandpassfilter (5), das eingerichtet ist, für jedes Messsignal ein gefiltertes Messsignal zu bilden, und
- eine Auswerteeinheit (7),
**dadurch gekennzeichnet, dass** die Auswerteeinheit (7) eingerichtet ist,
- für jedes Messsignal die erste Ableitung des Messsignals nach der Zeit und die erste Ableitung eines Leistungsdichtewertes des Messsignals nach der Zeit zu bestimmen, wobei der Leistungsdichtewert aus einer spektralen Leistungsdichte des Messsignals gebildet wird, und
- als Maß für die Stromstärke des Stroms einen gewichteten Mittelwert des Messsignals und des gefilterten Messsignals zu bilden, wobei das Gewicht des Messsignals mit steigender erster Ableitung des Messsignals nach der Zeit und mit steigender erster Ableitung des Leistungsdichtewertes nach der Zeit monoton zunimmt.

11. Messvorrichtung (1) nach Anspruch 10, wobei das Bandpassfilter (5) ein Tiefpassfilter ist.

12. Messvorrichtung (1) nach Anspruch 10 oder 11, wobei der Stromwandler (3) ein optischer Stromwandler ist.

13. Messvorrichtung (1) nach einem der Ansprüche 10 bis 12, wobei die Auswerteeinheit (7) eingerichtet ist, den Leistungsdichtewert durch Integration der spektralen Leistungsdichte des Messsignals über einen Frequenzbereich zu bilden.

## Claims

1. Method for measuring an electric current, wherein
- a measurement signal dependent on the current is acquired repeatedly,
- a filtered measurement signal is formed for each measurement signal in that the measurement signal is filtered with a bandpass filter (5),
**characterised in that**,
- for each measurement signal a first derivative of the measurement signal with respect to time and the first derivative of a power density value with respect to time are determined, wherein the power density value is formed from a spectral power density of the measurement signal, and
- a weighted mean value of the measurement signal and of the filtered measurement signal is formed as a measure for the amperage of the current, wherein the weight of the measurement signal increases monotonously with an increasing first derivative of the measurement signal with respect to time and with an increasing first derivative of the power density value with respect to time.

2. Method according to claim 1, wherein a stability factor is defined which decreases monotonously with an increasing first derivative of the measurement signal with respect to time and with an increasing first derivative of the power density value with respect to time, and the weighted mean value of the measurement signal and of the filtered measurement signal is formed with the stability factor in such a way that the weight of the measurement signal decreases with an increasing stability factor and the weight of the filtered measurement signal increases with an increasing stability factor.

3. Method according to claim 2, wherein the stability factor is assigned values in the interval [0,1] and the weighted mean value is formed according to A·(1-S) + B·S, wherein A denotes the measurement signal, B denotes the filtered measurement signal, and S denotes the value of the stability factor.

4. Method according to claim 2 or claim 3, wherein a first threshold value is specified for the first derivative of the measurement signal with respect to time, and the stability factor is defined such that it assumes a minimum of its value range for all the values of the first derivative of the measurement signal with respect to time which exceed the first threshold value.

5. Method according to any one of claims 2 to 4, wherein a second threshold value is specified for the first derivative of the power density value with respect to time, and the stability factor is defined such that it assumes a minimum of its value range for all the values of the first derivative of the power density value with respect to time which exceed the second threshold value.

6. Method according to any one of claims 2 to 5, wherein a third threshold value is specified for the first derivative of the measurement signal with respect to time, and the stability factor is defined such that it assumes a maximum of its value range for all the values of the first derivative of the measurement signal with respect to time which fall below the third threshold value.

7. Method according to any one of claims 2 to 6, wherein a fourth threshold value is specified for the first derivative of the power density value with respect to time, and the stability factor is defined such that it assumes a maximum of its value range for all the values of the first derivative of the power density value with respect to time which fall below the fourth threshold value.

8. Method according to any one of the preceding claims, wherein the bandpass filter (5) is a lowpass filter.

9. Method according to any one of the preceding claims, wherein the power density value is formed by integration of the spectral power density of the measurement signal over a frequency range.

10. Measuring device (1) for measuring an electric current, comprising
- a current transducer (3) which is configured for repeatedly acquiring a measurement signal dependent on the current,
- a bandpass filter (5) which is configured for forming a filtered measurement signal for each measurement signal, and
- an evaluation unit (7),
**characterised in that** the evaluation unit (7) is configured
- for determining, for each measurement signal, the first derivative of the measurement signal with respect to time and the first derivative of a power density value of the measurement signal with respect to time, wherein the power density value is formed from a spectral power density of the measurement signal, and
- for forming a weighted mean value of the measurement signal and of the filtered measurement signal as a measure for the amperage of the current, wherein the weight of the measurement signal increases monotonously with an increasing first derivative of the measurement signal with respect to time and with an increasing first derivative of the power density value with respect to time.

11. Measuring device (1) according to claim 10, wherein the bandpass filter (5) is a lowpass filter.

12. Measuring device (1) according to claim 10 or claim 11, wherein the current transducer (3) is an optical current transducer.

13. Measuring device (1) according to any one of claims 10 to 12, wherein the evaluation unit (7) is configured for forming the power density value by integration of the spectral power density of the measurement signal over a frequency range.

## Revendications

1. Procédé de mesure d'un courant électrique, dans lequel
- un signal de mesure dépendant du courant est détecté de manière répétée,
- pour chaque signal de mesure, un signal de mesure filtré est formé en filtrant le signal de mesure au moyen d'un filtre passe-bande (5),
**caractérisé en ce que**
- pour chaque signal de mesure, il est déterminé la dérivée première du signal de mesure par rapport au temps et la dérivée première d'une valeur de densité de puissance par rapport au temps, la valeur de densité de puissance étant formée à partir d'une densité de puissance spectrale du signal de mesure, et
- une valeur moyenne pondérée du signal de mesure et du signal de mesure filtré est calculée en tant que mesure de l'intensité du courant, la pondération attribuée au signal de mesure augmentant de manière monotone à mesure qu'augmentent la dérivée première du signal de mesure par rapport au temps et la dérivée première de la valeur de densité de puissance par rapport au temps.

2. Procédé selon la revendication 1, dans lequel il est défini un facteur de stabilité qui diminue de façon monotone à mesure qu'augmentent la dérivée première du signal de mesure par rapport au temps et la dérivée première de la valeur de densité de puissance par rapport au temps, et la moyenne pondérée du signal de mesure et du signal de mesure filtré est calculée au moyen du facteur de stabilité de telle sorte que la pondération attribuée au signal de mesure diminue à mesure que le facteur de stabilité augmente et que la pondération attribuée au signal de mesure filtré augmente à mesure que le facteur de stabilité augmente.

3. Procédé selon la revendication 2, dans lequel des valeurs comprises dans l'intervalle [0, 1] sont attribuées au facteur de stabilité, et la moyenne pondérée est calculée selon la formule A·(1-S) + B·S, dans laquelle A désigne le signal de mesure, B désigne le signal de mesure filtré et S désigne la valeur du facteur de stabilité.

4. Procédé selon la revendication 2 ou la revendication 3, dans lequel une première valeur seuil est prédéfinie pour la dérivée première du signal de mesure par rapport au temps, et le facteur de stabilité est défini de telle sorte qu'il prenne une valeur minimale de son intervalle de valeurs pour toutes les valeurs de la dérivée première du signal de mesure par rapport au temps qui dépassent la première valeur seuil.

5. Procédé selon l'une des revendications 2 à 4, dans lequel une deuxième valeur seuil est prédéfinie pour la dérivée première de la valeur de la densité de puissance par rapport au temps, et le facteur de stabilité est défini de telle sorte qu'il prenne une valeur minimale de son intervalle de valeurs pour toutes les valeurs de la dérivée première de la valeur de la densité de puissance par rapport au temps qui dépassent la deuxième valeur seuil.

6. Procédé selon l'une des revendications 2 à 5, dans lequel une troisième valeur seuil est définie pour la dérivée première de la valeur de la densité de puissance par rapport au temps, et le facteur de stabilité est défini de telle sorte qu'il atteigne un maximum de son intervalle de valeurs pour toutes les valeurs de la dérivée première de la valeur de la densité de puissance par rapport au temps qui sont inférieures à la troisième valeur seuil.

7. Procédé selon l'une des revendications 2 à 6, dans lequel une quatrième valeur seuil est prédéfinie pour la dérivée première de la valeur de la densité de puissance en fonction du temps, et le facteur de stabilité est défini de telle sorte qu'il atteigne un maximum de son intervalle de valeurs pour toutes les valeurs de la dérivée première de la valeur de la densité de puissance en fonction du temps qui sont inférieures à la quatrième valeur seuil.

8. Procédé selon l'une des revendications précédentes, dans lequel le filtre passe-bande (5) est un filtre passe-bas.

9. Procédé selon l'une des revendications précédentes, dans lequel la valeur de la densité de puissance est obtenue par intégration de la densité de puissance spectrale du signal de mesure sur une plage de fréquences.

10. Dispositif de mesure (1) destiné à mesurer un courant électrique, comprenant
- un transformateur de courant (3), qui est agencé pour détecter de manière répétée un signal de mesure dépendant dudit courant,
- un filtre passe-bande (5), qui est agencé pour former, pour chaque signal de mesure, un signal de mesure filtré, et
- une unité d'évaluation (7),
**caractérisé en ce que** l'unité d'évaluation (7) est agencée de manière à
- déterminer, pour chaque signal de mesure, la dérivée première du signal de mesure par rapport au temps et la dérivée première d'une valeur de densité de puissance du signal de mesure par rapport au temps, la valeur de densité de puissance étant formée à partir d'une densité de puissance spectrale du signal de mesure, et
- former, en tant que mesure de l'intensité du courant, une valeur moyenne pondérée du signal de mesure et du signal de mesure filtré, la pondération attribuée au signal de mesure augmentant de manière monotone à mesure qu'augmentent la dérivée première du signal de mesure par rapport au temps et la dérivée première de la valeur de densité de puissance par rapport au temps.

11. Dispositif de mesure (1) selon la revendication 10, dans lequel le filtre passe-bande (5) est un filtre passe-bas.

12. Dispositif de mesure (1) selon la revendication 10 ou la revendication 11, dans lequel le transformateur de courant (3) est un transformateur de courant optique.

13. Dispositif de mesure (1) selon l'une des revendications 10 à 12, dans lequel l'unité d'évaluation (7) est agencée de manière à calculer la valeur de la densité de puissance par intégration de la densité de puissance spectrale du signal de mesure sur une plage de fréquences.
